**Europäisches Patentamt**

**European Patent Office**

**Office européen des brevets**

(19)

(11) Publication number: **0 124 264**
**B1**

(12) # EUROPEAN PATENT SPECIFICATION

(45) Date of publication of patent specification: **19.11.87**

(51) Int. Cl.⁴: **H 01 R 13/66, H 03 H 1/00**

(21) Application number: **84302142.9**

(22) Date of filing: **29.03.84**

(54) Filter connector.

(30) Priority: **30.03.83 US 480592**

(43) Date of publication of application:
**07.11.84 Bulletin 84/45**

(45) Publication of the grant of the patent:
**19.11.87 Bulletin 87/47**

(84) Designated Contracting States:
**AT BE CH DE FR GB IT LI LU NL SE**

(56) References cited:
**DE-A-2 600 320**
**DE-A-2 925 374**
**DE-A-3 016 315**
**US-A-3 538 464**
**US-A-4 144 509**

(73) Proprietor: **E.I. DU PONT DE NEMOURS AND COMPANY**
**1007 Market Street**
**Wilmington Delaware 19898 (US)**

(72) Inventor: **Bakermans, Frank C.**
**316 Somerset Drive**
**Shiremanstown Pennsylvania 17011 (US)**
Inventor: **Trexler, Charles Joseph**
**1816 W. Philadelphia Street**
**York Pennsylvania 17404 (US)**

(74) Representative: **Barnard, Eric Edward et al**
**BROOKES & MARTIN High Holborn House 52/54**
**High Holborn**
**London WC1V 6SE (GB)**

Courier Press, Leamington Spa, England.

## Description

Field of the Invention

This invention relates to an electrical filter connector for reducing electromagnetic interference.

Background of the Invention

Filter connectors have been employed for decades to attenuate high frequency electrical signals, especially for military purposes. These filters have been relatively sophisticated and expensive. In recent years, the common usage of computers and particularly home computers has resulted in the generation of significant additional amounts of high frequency electromagnetic signals interfering with other electrical devices. For the purpose of reducing the output of such signals, the United States Federal Communications Commission (FCC) has promulgated regulations requiring attenuation at their source. See 47 CR 15, Subpart J.

Known prior art publications are: US—A—4 144 509, US—A—4 079 343, US—A—3 538 464, DE—A—3 016 315, and DE—A—2 925 374. Available commercial filters employing ferrite sleeves (US—A—4 144 509) or monolithic capacitors structures with or without ferrites (US—A—3 538 464) are expensive for use in low-cost electronic equipment such as the personal computer. DE—A—2 925 374 describes an electrical filter connector with monolithic capacitors connected to conductive pins and plates serving as ground planes which connect common electrodes of the capacitors to a housing. A need exists for an inexpensive filter connector that will satisfactorily attenuate electromagnetic signals at ultrahigh frequencies, i.e., up to 1000 megahertz (MHz). A useful commercial filter would attenuate the electromagnetic signal at least 30 decibels (dB) at a 1000 MHz frequency.

Summary of the Invention

As is known from DE—A—2 925 374 the present invention relates to a filter connector of the type comprising a conductive housing, a filter member enclosed by the housing, and conductive pins mounted to the filter member. In DE—A—2 925 374 ground planes are spaced from the filter member and in contact with the housing and the filter member is composed of multiple monolithic capacitors each having a first electrode in electrical contact with the housing through the ground plane or planes, a second electrode in electrical contact with a respective adjacent one of said pins and a dielectric therebetween.

In accordance with the invention one or more ground planes are provided at least adjacent to the filter member and in direct electrical contact with the housing through which the pins pass without contact and means is provided to establish direct electrical contact between the first electrodes of the capacitors and the housing.

The or each ground plane may take the form of a metallic plate spaced from the filter member or a metallization layer deposited on one side of the filter member or otherwise spaced therefrom. The capacitors are preferably thick film capacitors produced by screen printing multiple layers onto a substrate conveniently an alumina sheet.

In one embodiment one ground plane is a thick film metallization layer on a horizontal surface of a rectangularly shaped alumina substrate and another horizontal surface of the alumina substrate has a screen printed metallization layer forming said first capacitor electrode followed by two screen printed layers of barium titanate forming the dielectric, another screen printed metallization layer forming said second capacitor electrode and at least one layer of a glass encapsulant. A first set of solder joints may establish the direct electrical connection between the first electrodes and the housing while further solder joints connect the or each ground plane to the housing. Another set of solder joints may connect the conductive pins to the second electrodes.

This invention provides an inexpensive electrical filter connector for effectively filtering a wide band of frequencies up to 1000 MHz.

Brief Description of the Drawings

The present invention may be best understood by those having ordinary skill in the art by reference to the following detailed description when considered in conjunction with the accompanying drawings in which:

Fig. 1 is an isometric assembly, partially sectioned, of one form of filter connector constructed in accordance with the invention;

Fig. 2 is a part-sectional elevation of the connector of Fig. 1;

Fig. 3 is a transverse sectional view along 3—3 of Fig. 1;

Fig. 4 is an exploded view of the parts of the connector shown in Fig. 1;

Fig. 5 is a section through the filter member and ground plane assembly of the connector shown in Fig. 1;

Fig. 6 is a section through the filter member and ground plane assembly of another embodiment of a filter connector;

Fig. 7 is a section through the filter member and ground plane assembly of a further embodiment of a filter connector;

Fig. 8 is a sectional view of a modified form of filter connector having a ferrite sleeve around each pin;

Fig. 9 is an exploded inverted view of the filter members shown in Figs. 5—7 and 11;

Fig. 10 is a perspective view of the filter member shown in Fig. 9;

Fig. 11 is a section through the filter member and ground plane assembly of another embodiment of a filter connector; and

Fig. 12 is a graph showing an attenuation curve for a filter connector without a ground plane and for the same filter connector having a pair of ground planes as shown in Fig. 5.

Description of Preferred Embodiments

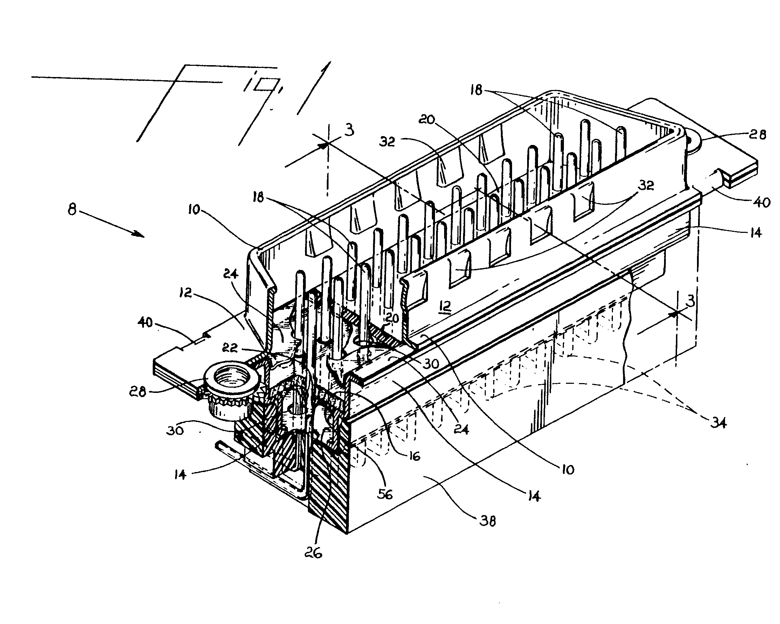

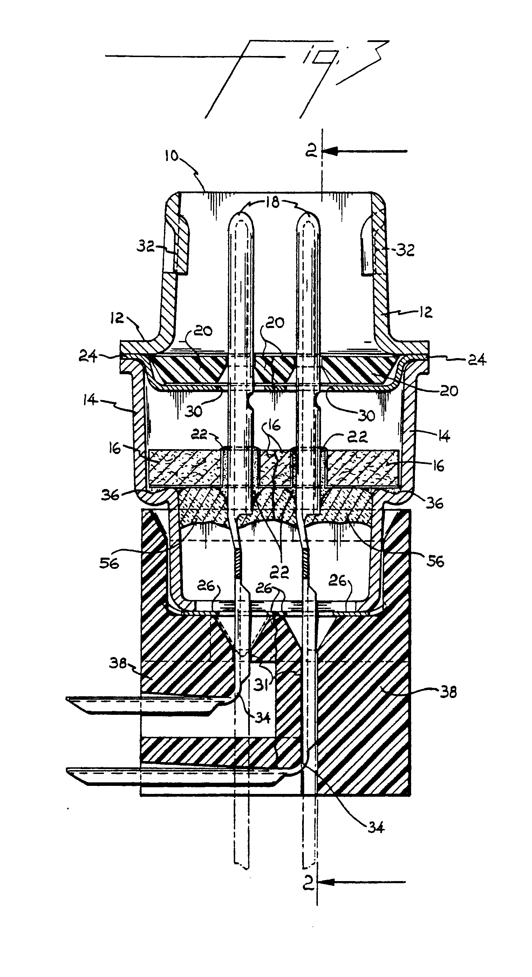

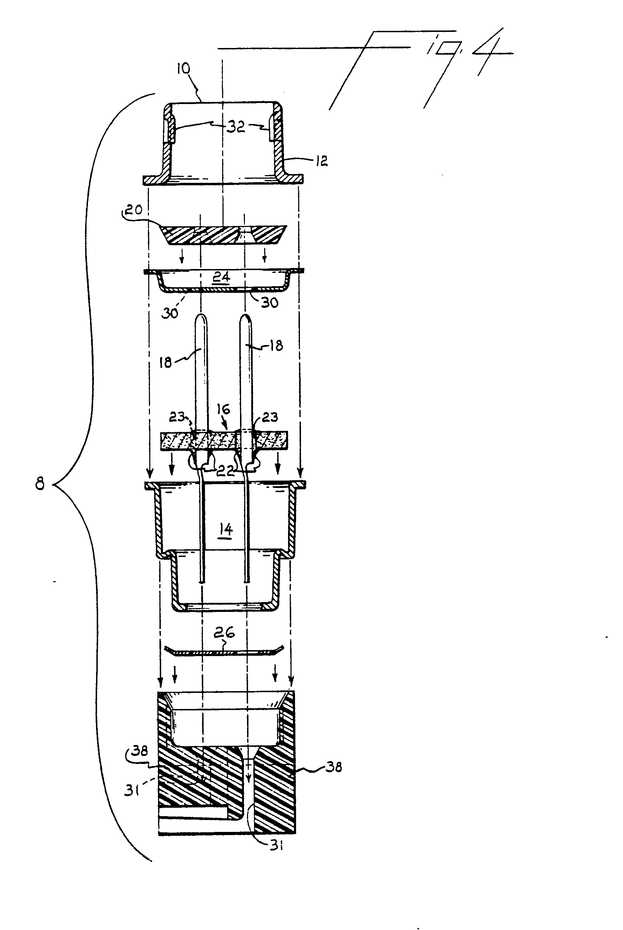

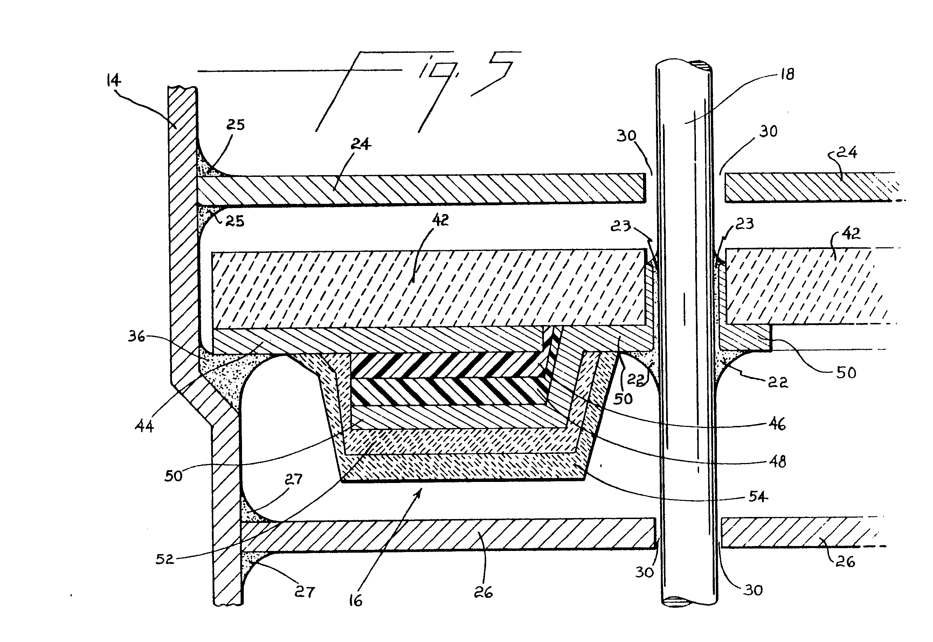

Referring first to Fig. 1, the filter connector 8 comprises a housing 10 made up of the top shell 12 and a bottom shell 14. Threaded inserts 28 are provided on the connector optionally to provide a mounting fixture to a cabinet. The interior of the connector 8 is protected by a top insulator 20 and a bottom insulator 38. The housing 10 encloses two rows of pins 18 mounted on a filter member 16. The pins 18 are individually mounted on the filter member 16 by solder joints 22. Contacts 32 are arranged in the top shell 12 to provide ground contact for a female plug (not shown) inserted over the pins 18. The two shells 12 and 14 are crimped together by tabs 40. The pins 18 can be either straight or right-angled as shown as 34 in Figs. 1—3. The filter member 16 consists of multiple thick film capacitor units each having a pair of electrodes 44, 50 separated by a dielectric 46, 48. A single capacitor unit for the filter member 16 is shown for illustration purposes in Figs. 5—7 and 11. The capacitors of the filter member 16 utilize a common alumina substrate 42 and each capacitor has an electrode in the form of a first metallization layer 44 screen printed to one surface of the substrate 42. This electrode or layer 44 is directly grounded to the shell 14 by solder joints 36. The metallization composition can contain a noble metal such as gold or a palladium/silver alloy, a binder and vehicle. The vehicle is removed during firing of the metallization. A dielectric material 46 and 48 is then screen printed over the electrode 44. The filter member 16 shown in Fig. 5 has two layers of barium titanate 46 and 48 which are screen printed over the electrode 44. Any other type of dielectric material commonly used in the preparation of capacitors can be substituted for the barium titanate. Although one layer of barium titanate may be sufficient, it is preferred that two layers of barium titanate be applied by screen printing to ensure against shorting. A second electrode 50 is prepared by screen printing another layer of noble metal metallization over the barium titanate dielectric. It is preferred that the metallizations contain palladium/silver. The electrode 50 is electrically in contact with the associated pin 18 through a solder joint 22. During assembly solder is allowed to enter the holes in the substrate 42 to seal the pins 18 to the electrode 50 as shown at 23 thereby to create the joints 22. The filter member 16 is encapsulated with one or more layers 52, 54 of a glass encapsulant to protect the porous dielectric 46 and 48 from moisture. The glass encapsulant can be any of the compositions commonly used in the industry to protect capacitors. Optionally, a silicone sealant 56 shown in Figs. 1—2, can be added around the glass encapsulant to prevent moisture from entering into the filter member 16.

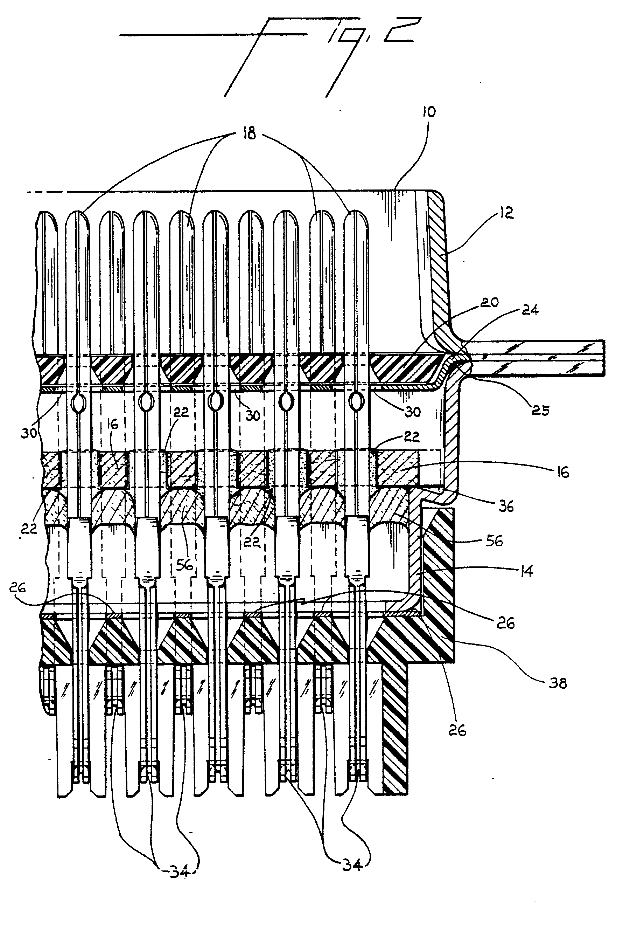

An added attenuation drop of at least thirty decibels at 1000 MHz is derived from this connector by using one or more ground planes 24 and 26. Each ground plane 24, 26 has holes 30 through which the pins 18 pass without touching the ground plane. Each ground plane 24 and 26 is soldered directly to the housing shell 14 with solder joints 25, 27 and Figs. 2 and 3 show some of the solder joints 25 connecting the top ground plane 24 to the shell 14. Figs. 3 and 4 show one of the several holes 31 in the bottom insulator 38 for accommodating the pins 18. In Figs. 1—5, the ground planes 24 and 26 are spaced apart from the filter member 16 and take the form of conductive metal plates.

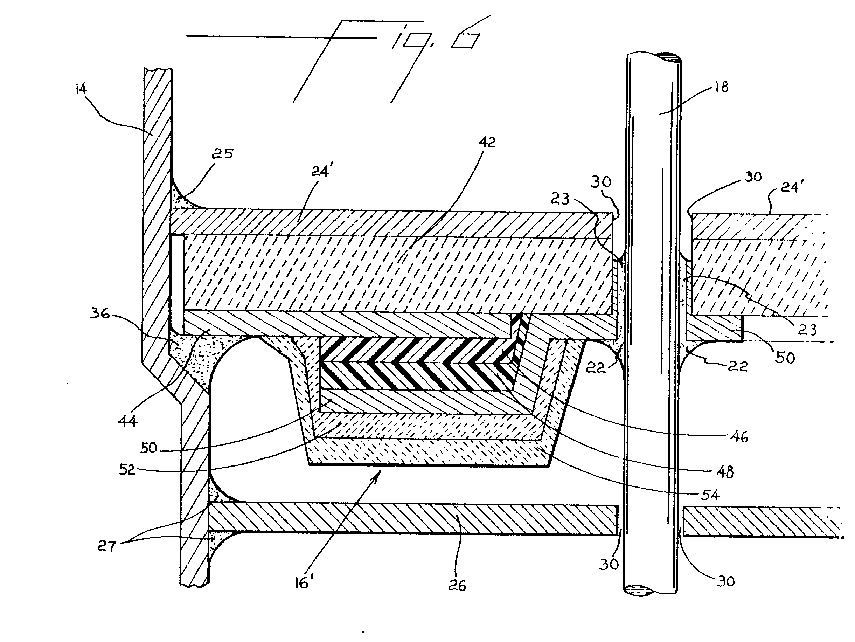

An alternative assembly of filter member and ground planes is set forth in Fig. 6. Filter member 16' can have the same configuration as set forth in Fig. 5. However, in this modified assembly the top ground plane 24' is a metallization layer screen-printed onto one surface of the alumina substrate 42. The metallization is preferably a noble metal such as palladium/silver alloy or gold. The bottom ground plane 26 is again a spaced apart metal plate as set forth in Fig. 5.

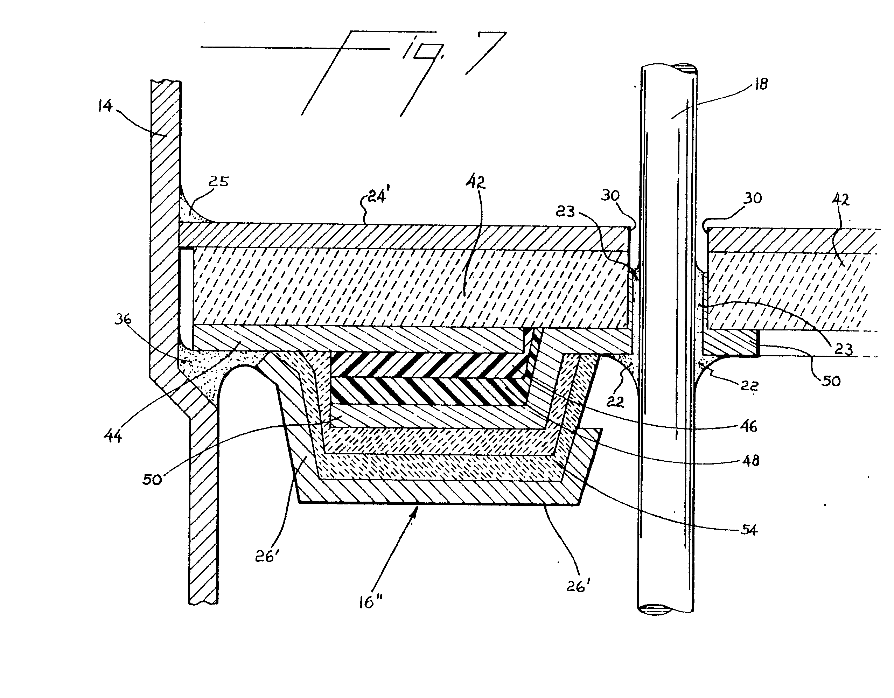

In Fig. 7, another alternative ground plane filter member assembly is set forth. In this instance, the bottom ground plane 26' differs from the spaced apart metal plate ground plane 26 of Fig. 6 by being a metallization such as palladium/silver screen printed onto the top of the glass encapsulant 54 of the filter member 16''. The ground plane 24' is the same as set forth in Fig. 6 and the filter member 16'' is also the same as 16' in Fig. 6.

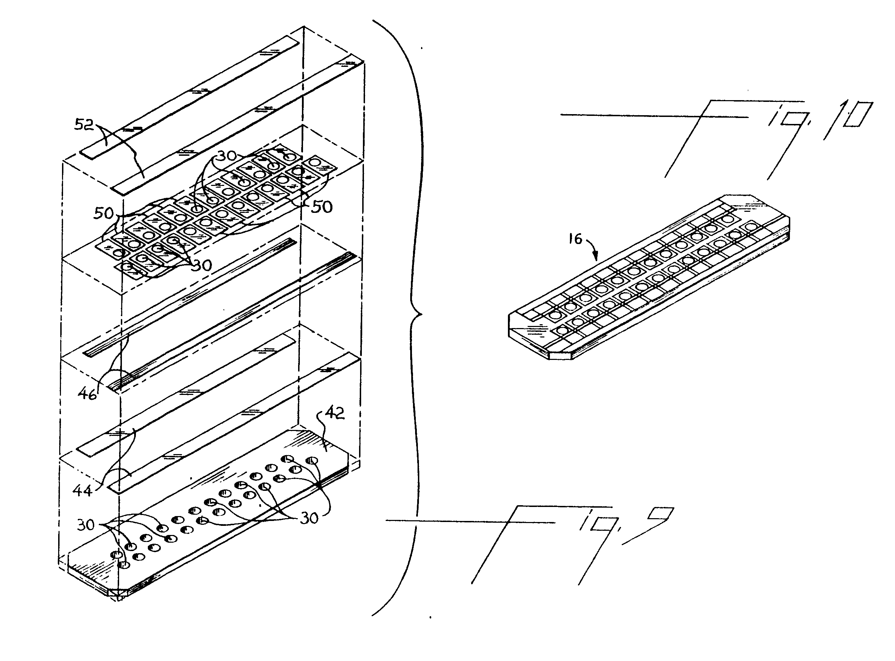

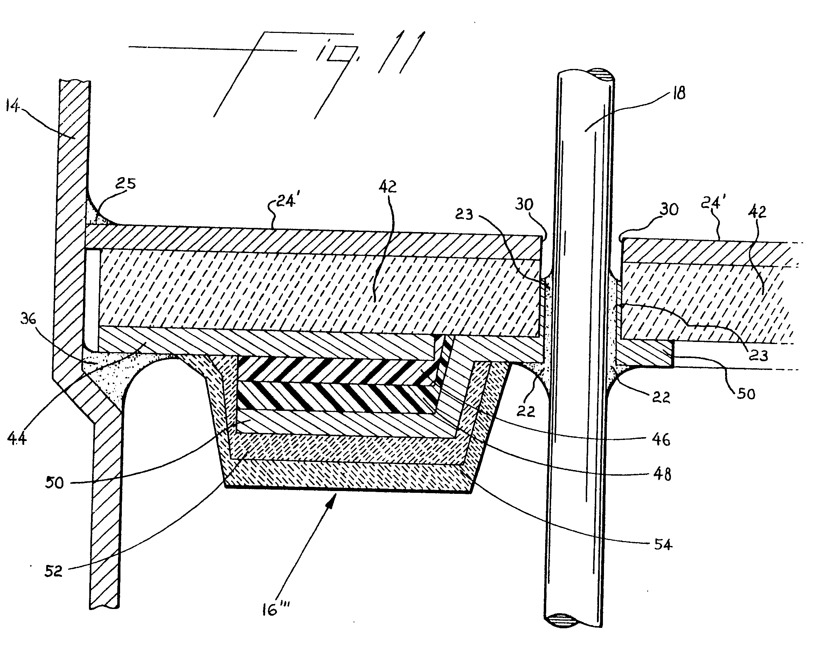

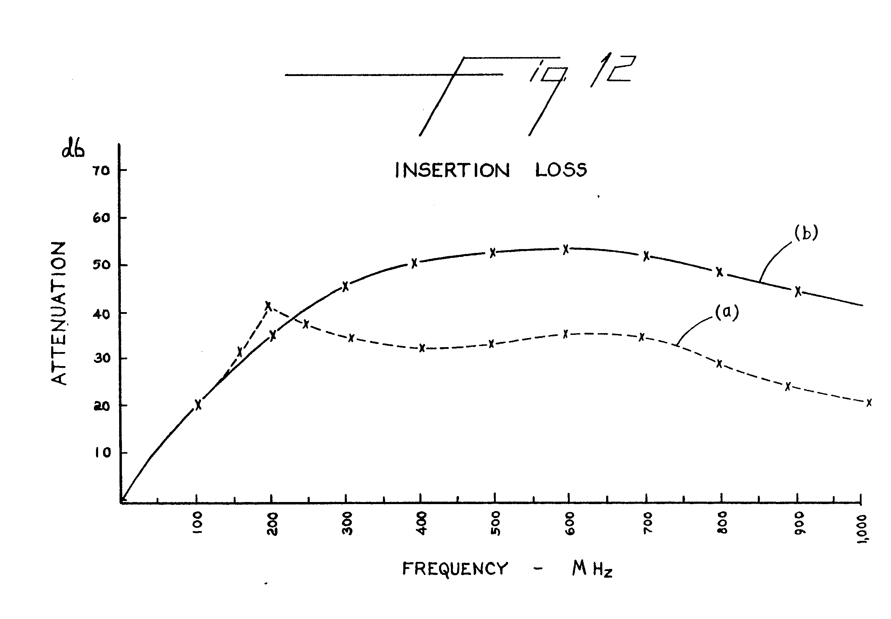

In Fig. 11, a third alternative ground plane filter member assembly is set forth. In this assembly only one ground plane 24' is employed in association with filter member 16'''. Ground plane 24' is the same as shown in Fig. 7. The only difference in this assembly from the one in Fig. 7 is the omission of the second ground plane 26'. Ground plane 24' could also be spaced apart from filter member 16''' as shown for ground plane 24 in Fig. 5.

The filter element can be made by the methods set forth above or it can be a monolithic structure made from green tape, as is well known in the prior art. In either case, the use of ground planes, with both spaced apart or with one or both ground planes screen printed adjacent to a side of the filter member, provides an added attenuation of electromagnetic signals up to 1000 MHz. A typical comparison of attenuation curves is shown in Fig. 12. Curve (a) shows an attenuation curve using a filter connector without a ground plane. Curve (b) is an attenuation curve for a filter connector employing the same filter member but having a pair of ground planes as shown in Fig. 5.

The metal in the spaced apart ground planes can be any conductive substance such as steel, brass, copper, silver, gold, palladium, platinum or alloys thereof.

The metallization compositions useful in producing the ground planes 24' and 26' screen printed directly to the filter member 16'' as shown in Fig. 7 are finely divided metal particles together with binder and vehicle screen printed on alumina subsurfaces or onto glass encapsulant layers covering thick film capacitors. The dispersion of the metal particles is usually in an inert liquid organic medium or vehicle. Selection of the composition of the metal particles is usually based on a compromise of cost and performance. Performance usually suggests the use of the noble metals or their alloys because they are relatively inert during firing of the laminates to produce electrically continuous conductors. On the other hand, base metals are often oxidized in the air at elevated temperatures and in many cases react with the dielectric material during firing.

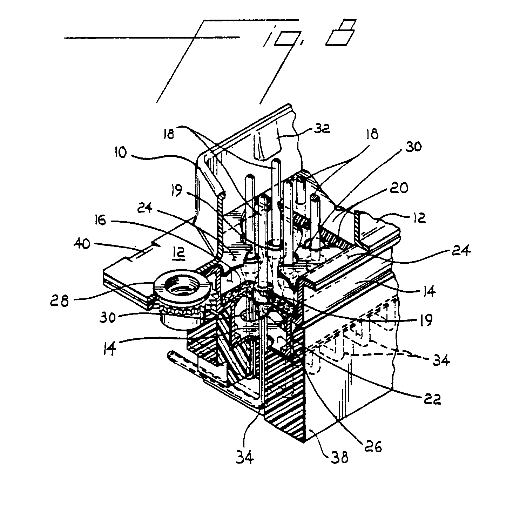

A ferrite sleeve 19 also can be provided on each of the pins 18, as seen in Fig. 8. Such sleeves are well known as seen in US—A—4 144 509 but the use of the ground planes of this invention will increase the effectiveness of filter connectors employing ferrites.

**Claims**

1. An electrical connector for filtering a wide band of frequencies; the connector having a conductive housing (10), a filter member (16) enclosed by the housing, conductive pins (18) mounted to the filter member (16), the filter member (16) being composed of multiple capacitors each having a first electrode (44) in electrical contact with the housing (10), a second electrode (50) in electrical contact with a respective adjacent one of said pins (18) and a dielectric (46, 48) therebetween; characterized in that one or more ground planes (24, 26) are provided at least adjacent to the filter member and in electrical contact with the housing (10) through which the pins (18) pass without contact and means (36) is provided to establish direct electrical contact between the first electrodes (44) of the capacitors and the housing (10).

2. An electrical connector according to claim 1, wherein two metal plates (24, 26) serving as ground planes are provided and the ground planes (24, 26) are spaced from the filter member (16) with one ground plane on either side of the filter member.

3. An electrical connector according to claim 1, wherein a single ground plane (24') is provided and the ground plane is spaced apart from one side of the filter member (16).

4. An electrical connector according to claim 1, wherein a single ground plane (24') is provided as a metallization layer on one side of the filter member.

5. An electrical connector according to claim 1, wherein a metallization layer (24') forming one ground plane is placed on one side of the filter member (16) and a metal plate (26) forming another ground plane is spaced from the other side of the filter member (16).

6. An electrical connector according to claim 1, wherein metallized layers (24', 26') forming two ground planes are placed on either side of the filter member (16).

7. An electrical connector according to claim 3, wherein the ground plane (24') is a metallization layer on a carrier.

8. An electrical connector according to claim 4, 5, 6 or 7, wherein the or each ground plane metallization layer (24', 26') is a noble metal.

9. An electrical connector according to claim 8, wherein the noble metal is a palladium/silver alloy.

10. An electrical connector according to claim 8, wherein the noble metal is gold.

11. An electrical connector according to any one of claims 1 to 10, wherein the multiple capacitors are thick film capacitors.

12. An electrical connector according to claim 11, wherein each thick film capacitor comprises a common alumina substrate (42) supporting one of the electrodes (44) formed from a thick film metallization, at least one layer of dielectric (46, 48) separating the one electrode (44) from the other electrode (50) also formed from a thick film metallization and a glass encapsulant (52, 54) surrounding the dielectric and electrode layers.

13. An electrical connector according to any one of claims 1 to 12, wherein the dielectric is one or more layers of barium titanate.

14. An electrical connector according to claim 1, wherein one ground plane is a thick film metallization layer (24') on a horizontal surface of a rectangularly shaped alumina substrate (42) and another horizontal surface of the alumina substrate has a screen printed metallization layer (44) forming said first capacitor electrode followed by two screen printed layers (46, 48) of barium titanate forming the dielectric, another screen printed metallization layer forming said second capacitor electrode (50) and at least one layer (52, 54) of a glass encapsulant.

15. An electrical connector according to claim 14, wherein another ground plane is a thick film metallization layer (26') on the glass encapsulated layer (52, 54).

16. An electrical connector according to any one of claims 1 to 15, wherein each conductive pin (18) is at least partially enclosed by a ferrite sleeve (19).

17. An electrical connector according to claim 1, wherein the filter member (16) employs monolithic capacitors.

18. An electrical connector according to any one of claims 1 to 17, wherein a first set of solder joints (36) establish the direct electrical contact between the first electrodes (44) and the housing (10), a second set of solder joints (22) serve to connect the pins (18) to the second electrodes (50) and further solder joints (25, 27) serve to connect the or each ground plane (24, 26) to the housing (10).

**Patentansprüche**

1. Elektrischer Verbinder zum Ausfiltern eines breiten Frequenzbandes, wobei der Verbinder ein leitendes Gehäuse (10), ein Filterelement (16), das von dem Gehäuse umschlossen ist, und leitende Stifte (18) hat, die am Filterelement (16) angebracht sind, und wobei das Filterelement (16) aus mehreren Kondensatoren besteht, die jeweils eine erste Elektrode (44), die in elektrischem Kontakt mit dem Gehäuse (10) ist, eine zweite Elektrode (50), die in elektrischem Kontakt mit einem entsprechend benachbarten Stift (18) ist und ein Dielektrikum (46, 48) hat, das dazwischen liegt, dadurch gekennzeichnet, daß ein oder mehrere Erdungsebenen (24, 26) wenigstens dem Filterelement benachbart und in elektrischem Kontakt mit dem Gehäuse (10) vorgesehen ist oder sind, durch das die Stifte (18) ohne Kontakt gehen, und daß eine Einrichtung (36) vorgesehen ist, um einen direkten elektrischen Kontakt zwischen den ersten Elektroden (44) der Kondensatoren und dem Gehäuse (10) herzustellen.

2. Elektrischer Verbinder nach Anspruch 1, bei dem zwei Metallplatten (24, 26), die als Erdungsebenen dienen, vorgesehen sind, und daß die Erdungsebenen (24, 26) von dem Filterelement (16) im Abstand angeordnet sind, wobei eine Erdungsplatte auf jeder Seite des Filterelements vorgesehen ist.

3. Elektrischer Verbinder nach Anspruch 1, bei dem eine einzige Erdungsebene (24') vorgesehen ist und die Erdungsebene einen Abstand von einer Seite des Filterelements (16) hat.

4. Elektrischer Verbinder nach Anspruch 1, bei dem eine einzige Erdungsebene (24') als eine Metallisierungsschicht auf einer Seite des Filterelements vorgesehen ist.

5. Elektrischer Verbinder nach Anspruch 1, bei dem eine Metallisierungsschicht (24'), die eine Erdungsebene bildet, auf einer Seite des Filterelements (16) sich befindet und eine Metallplatte (26), die eine andere Erdungsebene bildet, in einem Abstand von der anderen Seite des Filterelements (16) angeordnet ist.

6. Elektrischer Verbinder nach Anspruch 1, bei dem die metallisierten Schichten (24', 26'), die die beiden Erdungsebenen bilden, auf jeder Seite des Filterelements (16) vorgesehen sind.

7. Elektrischer Verbinder nach Anspruch 3, bei dem die Erdungsebene (24') eine Metallisierungsschicht auf einem Träger ist.

8. Elektrischer Verbinder nach Anspruch 4, 5, 6 oder 7, bei dem die oder jede Metallisierungsschicht (24', 26') der Erdungsebene ein Edelmetall ist.

9. Elektrischer Verbinder nach Anspruch 8, bei dem des Edelmetall eine Palladium-Silberlegierung ist.

10. Elektrischer Verbinder nach Anspruch 8, bei dem das Edelmetall Gold ist.

11. Elektrischer Verbinder nach einem der Ansprüche 1 bis 10, bei dem die mehreren Kondensatoren Dickschichtkondensatoren sind.

12. Elektrischer Verbinder nach Anspruch 11, bei dem jeder Dickschichtkondensator ein gemeinsames Aluminiumoxidsubstrat (42) aufweist, das eine der Elektroden (44) trägt, die von einer Dickschichtmetallisierung gebildet werden, bei dem wenigstens eine dielektrische Schicht (46, 48) diese eine Elektrode (44) von den anderen Elektroden (50) trennt, die ebenfalls von einer Dickschichtmetallisierung gebildet werden, und bei dem eine Glaseinkapselung (52, 54) die dielektrischen Schichten und Elektrodenschichten umgibt.

13. Elektrischer Verbinder nach einem der Ansprüche 1 bis 12, bei dem das Dielektrikum ein oder mehrere Schichten aus Bariumtitanat ist.

14. Elektrischer Verbinder nach Anspruch 1, bei dem eine Erdungsebene eine Dickschichtmetallisierungsschicht (24') auf einer horizontalen Fläche eines rechteckförmigen Aluminiumoxidsubstrates (42) ist und bei dem eine andere horizontale Fläche des Aluminiumoxidsubstrats eine siebgedruckte Metallisierungsschicht (44) hat, die die erste Kondensatorelektrode bildet und auf die zwei siebgedruckte Schichten (46, 48) aus Bariumtitanat folgen, die das Dielektrikum bilden, dann eine weitere siebgedruckte Metallisierungsschicht, die die zweite Kondensatorelektrode (50) bildet und wenigstens eine Schicht (52, 54) aus einer Glaseinkapselung folgen.

15. Elektrischer Verbinder nach Anspruch 14, bei dem eine weitere Erdungsebene eine Dickschichtmetallisierungsschicht (26') auf der glaseingekapselten Schicht (52, 54) ist.

16. Elektrischer Verbinder nach einem der Ansprüche 1 bis 15, bei dem jeder leitende Stift (18) wenigstens teilweise von einer Ferrithülse (19) umschlossen ist.

17. Elektrischer Verbinder nach Anspruch 1, bei dem das Filterelement (16) monolithische Kondensatoren verwendet.

18. Elektrischer Verbinder nach einem der Ansprüche 1 bis 17, bei dem ein erster Satz von Lötverbindungen (36) den direkten elektrischen Kontakt zwischen den ersten Elektroden (44) und dem Gehäuse (10) herstellt, ein zweiter Satz von Lötverbindungen (22) dazu dient, die Stifte (18) mit den zweiten Elektroden (15) zu verbinden und weitere Lötverbindungen (25, 27) dazu dienen, die oder jede Erdungsebene (24, 26) mit dem Gehäuse (10) zu verbinden.

**Revendications**

1. Connecteur électrique pour filtrer une large bande de fréquences, ce connecteur comportant un boîtier conducteur (10), un filtre (16) enfermé par le boîtier, des broches conductrices (18) montées sur le filtre (16), ce filtre étant formé de plusieurs condensateurs ayant chacun une première électrode (44) en contact électrique avec le boîtier (10), une seconde électrode (50) en contact électrique avec l'une desdites broches qui lui est adjacente (18), et un diélectrique (46, 48) entre-elles, caractérisé en ce qu'il est prévu un ou plusieurs plans de masse (24, 26), adjacents au moins au filtre, en contact électrique avec le boîtier (10), et que les broches (18) traversent sans contact, et des moyens (36) pour établir un contact électrique direct entre les premières électrodes (44) des condensateurs et le boîtier (10).

2. Connecteur électrique suivant la revendication 1, dans lequel il est prévu deux plaques en métal (24, 26) servant de plans de masse, lesdits plans de masse (24, 26) étant espacés du filtre (16), avec un plan de masse sur chaque côté du filtre.

3. Connecteur électrique suivant la revendication 1, dans lequel il est prévu un seul plan de masse (24'), ce plan de masse étant espacé d'un côté du filtre (16).

4. Connecteur électique suivant la revendication 1, dans lequel il est prévu un seul plan de masse (24') sous la forme d'une couche de métallisation située sur un côté du filtre.

5. Connecteur électrique suivant la revendication 1, dans lequel une couche de métallisation (24') formant un plan de masse est située sur un côté du filtre (16) et une plaque de métal (26) formant un autre plan de masse est espacée de l'autre côté du filtre (16).

6. Connecteur électrique suivant la revendication 1, dans lequel des couches métallisées (24', 26') formant deux plans de masse sont situées de chaque côté du filtre (16).

7. Connecteur électrique suivant la revendication 3, dans lequel le plan de masse (24') est une couche de métallisation sur un support.

8. Connecteur électrique suivant la revendication 4, 5, 6 ou 7, dans lequel la couche de métallisation du ou de chaque plan de masse (24', 26') est en un métal noble.

9. Connecteur électrique suivant la revendication 8, dans lequel le métal noble est un alliage de palladium et d'argent.

10. Connecteur électrique suivant la revendication 8, dans lequel le métal noble est l'or.

11. Connecteur électrique suivant l'une quelconque des revendications 1 à 10, dans lequel les différents condensateurs sont des condensateurs à couche épaissé.

12. Connecteur électrique suivant la revendication 11, dans lequel chaque condensateur à couche épaisse comprend un substrat commun (42) d'alumine portant l'une des électrodes (44) formée d'une métallisation en couche épaisse, au moins une couche de diélectrique (46, 48) séparant la première électrode (44) de l'autre électrode (50) formée également par métallisation en couche épaisse, et une capsule en verre (52, 54) entourant le diélectrique et les couches d'électrodes.

13. Connecteur électrique suivant l'une quelconque des revendications 1 à 12, dans lequel le diélectrique est constitué d'une ou plusieurs couches de titanate de barium.

14. Connecteur électrique suivant la revendication 1, dans lequel un plan de masse est une couche (24') de métallisation en couche épaisse sur une surface horizontale d'un substrat (42) d'alumine de forme rectangulaire et une autre surface horizontale du substrat d'alumine comporte une couche de métallisation (44) imprimée au pouchoir formant l'électrode du premier condensateur suivie par deux couches (46, 48) de titanate de barium imprimées au pochoir, formant le diélectrique, par une autre couche de métallisation imprimée au pochoir formant l'électrode (50) dudit second condensateur et par au moins une couche (52, 54) de verre d'encapsulage.

15. Connecteur électrique suivant la revendication 14, dans lequel un autre plan de masse est une couche (26') de métallisation en couche épaisse située sur la couche (52, 54) de verre d'encapsulage.

16. Connecteur électrique suivant l'une quelconque des revendications 1 à 15, dans lequel chaque broche conductrice (18) est au moins partiellement enfermée par un manchon ferrite (19).

17. Connecteur électrique suivant la revendication 1, dans lequel le filtre (16) utilise des condensateurs monolithiques.

18. Connecteur électrique suivant l'une quelconque des revendications 1 à 17, dans lequel une première série de joints (36) de soudure établissent le contact électrique direct entre les premières électrodes (44) et le boîtier (10), une seconde série de joints de soudure (22) servant à connecter les broches (18) aux secondes électrodes (50) et 'd'autres joints de soudures (25, 27) servant à connecter le plan de masse ou chaque plan de masse (24, 26) au boîtier (10).

Fig. 1

0 124 264

Fig. 2

2

Fig. 3

Fig. 5

Fig. 6

Fig. 7

Fig. 8

Fig. 10

16

Fig. 9

52
50
50
46
44
42
30
30
30
30

Fig. 11

0 124 264

Fig 12

INSERTION LOSS